# EUROPEAN PATENT APPLICATION

(11) **EP 4 711 493 A1**
(43) Date of publication of application: **18.03.2026**
(21) Application number: 24825623.2
(22) Date of filing: 20.05.2024
(51) Int. Cl.: C23C 28/00, B32B 7/023, B32B 9/00, C25D 11/26

(54) **STRUCTURAL COLOR MEMBER AND METHOD FOR MANUFACTURING THE SAME**

(30) Priority: 23.06.2023 JP 2023103649
(71) Applicant: UACJ Corporation, Chiyoda-ku Tokyo 100-0004 (JP); National University Corporation Hokkaido University, Hokkaido 060-0808 (JP)
(72) Inventor: KIKUCHI Tatsuya, Sapporo-shi, Hokkaido 060-0808 (JP); ASHIZAWA Raiko, Sapporo-shi, Hokkaido 060-0808 (JP); NAKAJIMA Daiki, Tokyo 100-0004 (JP)
(74) Representative: Kramer Barske Schmidtchen Patentanwälte PartG mbB
(86) International application number: PCT/JP2024/018441
(87) International publication number: WO 2024/262215

(57) **Abstract**

A structurally colored material (1) includes a substrate (2) and an oxide film (3), which is composed of a metal oxide and which covers the substrate (2). The oxide film (3) includes a porous layer (31), which contains a plurality of pores (311), and which is disposed on the substrate (2), and a dense layer (32), which does not contain pores (311) and which is layered on the porous layer (31). When the thickness of the oxide film (3) is measured at various locations, the thickness of the oxide film (3) at each measurement location is within the range of 150 nm or more and 1000 nm or less and within the range of 0.75 times or more and 1.25 times or less with respect to the mean value of the thickness of the oxide film (3).

## Description

### TECHNICAL FIELD

The present invention relates to a structurally colored material and a method for manufacturing the same.

### BACKGROUND ART

Color members, to which chromatic color tones have been imparted, are used to enhance design characteristics in various fields such as building materials, exterior materials for transport vehicles, housings of electronic devices, and the like. Paints are often used to impart chromatic color tones to the surfaces of members. However, paints contain organic matter that is prone to deterioration due to various factors, such as exposure to ultraviolet rays. Therefore, there is a problem in that a color member, to which a chromatic color tone has been imparted by paint, is prone to peeling, as well as fading and deterioration, of the paint film during use.

In response to this, a technique has been proposed that uses optical interference to impart chromatic color tones to the surface of members, without using paint. For example, a titanium-based material resulting from covering, with a transparent covering layer, a surface of a titanium-based material on which an oxide film having an interference color has been formed is disclosed in Patent Document 1, the titanium-based material including a covering layer on the surface being characterized in that the thickness of the oxide film is 150 to 600 nm.

### PRIOR ART LITERATURE

### Patent Documents

Patent Document 1: Japanese Laid-open Patent Publication 2004-137514

### SUMMARY OF THE INVENTION

### PROBLEMS TO BE SOLVED BY THE INVENTION

In recent years, in order to further enhance the design characteristics of buildings, transport vehicles, electronic devices, and the like, it has been desirable to use structural colors to cause different color tones to be developed depending on the angle from which the surface of the member is viewed.

The present invention was made in consideration of this background, and is directed to providing a structurally colored member, which has structural color and which excels in durability, and a method for manufacturing the same.

### MEANS FOR SOLVING THE PROBLEMS

One aspect of the present invention is a structurally colored material including: a substrate; and
an oxide film, which is composed of a metal oxide and which covers the substrate,
wherein the oxide film includes:
   a porous layer, which contains a plurality of pores and which is disposed on the substrate,
   a dense layer, which does not contain pores and which is layered on the porous layer, and
when the thickness of the oxide film is measured at various locations, the thickness of the oxide film at each measurement location is within the range of 150 nm or more and 1000 nm or less and within the range of 0.75 times or more and 1.25 times or less with respect to the mean value of the thickness of the oxide film.

Another aspect of the present invention is a method of manufacturing the structurally colored material of the aforementioned aspect, wherein
a metal film is formed on the substrate by sputtering, and
thereafter, the oxide film is formed on the substrate by performing an anodizing treatment on the metal film under a condition of a maximum voltage of 80 V or more and 200 V or less.

### EFFECTS OF THE INVENTION

The oxide film in the structurally colored material includes a porous layer, which is disposed on the substrate, and a dense layer, which is layered on the porous layer. In addition, the thickness of the oxide film is within the specific range described above. By having the oxide film on the substrate, the structurally colored material can exhibit structural color and develop chromatic colors of different color tones depending on the angle of the direction of the line of sight with respect to the structurally colored material. In addition, because the oxide film is constituted from a metal oxide, the optical characteristics can be maintained over a long period of time. Therefore, the structurally colored material excels in durability and can exhibit structural color over long periods of time.

In addition, the method of manufacturing the structurally colored material allows the structurally colored material to be obtained by the simple method of performing an anodizing treatment on a metal film under the specific condition described above, after the metal film was formed on a substrate by a sputtering method.

As described above, according to the aforementioned aspects, a structurally colored material, which has structural color and which excels in durability, and a method for manufacturing the same can be provided.

### BRIEF DESCRIPTION OF THE DRAWINGS

FIG. 1 is a partial cross-sectional view that shows the principal parts of a structurally colored material in an exemplary embodiment.
FIG. 2 is a magnified photograph of a metal film formed on a substrate, in an exemplary embodiment.
FIG. 3 is a magnified photograph of an oxide film of Test Material A1 in an exemplary embodiment.

### MODES FOR CARRYING OUT THE INVENTION

### (Structurally Colored Material)

The substrate of the structurally colored material may be constituted from an organic material, such as a resin, or may be constituted from an inorganic material, such as a metal or a ceramic. The organic material used as the substrate may be, for example, a phenol resin, an epoxy resin, a polyolefin-based resin, a polycarbonate resin, a polyester resin, a vinyl chloride resin, a polystyrene resin, or the like. The inorganic material used as the substrate may be, for example, a metal such as iron, an iron alloy, aluminum, an aluminum alloy, copper, a copper alloy, titanium, or a titanium alloy, or may be a ceramic such as glass or indium tin oxide (ITO).

The substrate of the structurally colored material is preferably constituted from metal. In this case, the durability of the structurally colored material can be further increased. In addition, since substrates composed of metal are electrically conductive, when the metal film is subjected to anodizing treatment in the manufacturing process of the structurally colored material described below, imbalances in the voltage applied to the metal film can be further reduced. As a result, the oxide film can be formed on the substrate more easily.

In addition, it is more preferable that the substrate of the structurally colored material is constituted from aluminum or an aluminum alloy. Aluminum and aluminum alloys have a color tone known as silver-white, which is nearly colorless and has a high brightness. Therefore, by using a substrate composed of aluminum or an aluminum alloy, the influence of the color tone of the substrate on the color tone of the structurally colored material can be further reduced. As a result, the range of color tones that can be exhibited by the structurally colored material can be broadened.

The oxide film is formed on the substrate of the structurally colored material. The oxide film may cover the entire surface of the substrate or may cover a portion of the surface. In addition, the oxide film may be layered on the substrate and, between the oxide film and the substrate, a layer that is different from these may be provided.

When the thickness of the oxide film is measured at various locations of the oxide film, the thickness of the oxide film at each measurement location is within the range of 150 nm or more and 1000 nm or less and within the range of 0.75 times or more and 1.25 times or less with respect to the mean value of the thickness of the oxide film. By setting the thickness of the oxide film within the specific ranges described above, structural color can be exhibited and the structurally colored material can develop different color tones depending on the angle of the direction of the line of sight with respect to the structurally colored material.

In terms of the reasons for which such an effect is obtained, for example, the following reasons are conceivable. If the thickness of the oxide film is within the range of 150 nm or more and 1000 nm or less, the thickness of the porous layer can be made sufficiently thick. As the thickness of the porous layer increases, refraction and reflection of visible light incident on the oxide film are more likely to occur within the porous layer. Furthermore, it is conceivable that, due to interference of the light scattered by refraction and reflection within the porous layer, light of different color tones can be emitted from the oxide film, depending on the angle of the direction of the line of sight with respect to the structurally colored material.

In addition, by setting the thickness of the oxide film to within a range of 0.75 times or more and 1.25 times or less with respect to the mean value, variations in the thickness of the oxide film can be reduced, and the roughness of the surface of the oxide film can be reduced, as well as of interfaces where light can be reflected, such as the interface between the dense layer and the porous layer, and the interface between the porous layer and the layer below it. Furthermore, it is conceivable that, by reducing the roughness of these interfaces, diffused reflection of light at the interfaces is curtailed, and optical interference can more readily occur within the oxide film.

Accordingly, it is conceivable that, by making the thickness of the porous layer sufficiently thick and making the interfaces smooth, as described above, interference of reflected light is caused within the porous layer, such that structural color can be exhibited.

If a portion having a thickness of less than 150 nm is present in the oxide film, the thickness of the porous layer tends to be thin, and therefore there is a risk that the structural color will not readily be exhibited. On the other hand, if a portion that has a thickness that exceeds 1000 nm is present in the oxide film, there is a risk that the structurally colored material will not present chromatic color because visible light interference will be less likely to occur within the oxide film. From the viewpoint of more reliably exhibiting the structural color on the structurally colored material, when the thickness of the oxide film is measured at various locations of the oxide film, the thickness of the oxide film at each measurement location is preferably 150 nm or more and 800 nm or less, more preferably 150 nm or more and 600 nm or less, and is still more preferably 150 nm or more and 400 nm or less.

In addition, if a portion having a thickness that is less than 0.75 times or exceeds 1.25 times the mean value of the thickness of the oxide film is present in the oxide film, visible light incident on the oxide film tends to be reflected in a diffused manner, due to the variation in the thickness of the oxide film. Therefore, in this case, visible light interference will be less likely to occur within the oxide film and there is a risk that the structurally colored material will not present chromatic color. From the viewpoint of more reliably exhibiting the structural color on the structurally colored material, when the thickness of the oxide film is measured at various locations, the thickness of the oxide film at each measurement location is preferably 0.8 times or more and 1.2 times or less, more preferably 0.9 times or more and 1.1 times or less, and still more preferably 0.93 times or more and 1.07 times or less, with respect to the mean value thereof.

The thickness of the oxide film in the structurally colored material can be measured based on a magnified photograph obtained by transmission electron microscope (which is to say, TEM) observation.

The oxide film contains a porous layer containing a plurality of pores and a dense layer that does not contain pores. The oxide film may have a two-layer structure composed of a porous layer and a dense layer, or may have a multi-layer structure that includes a porous layer, a dense layer, and a layer different from these layers. From the viewpoint of more reliably exhibiting the structural color on the structurally colored material, it is preferable that the oxide film is constituted from a porous layer and a dense layer.

The porous layer contains a plurality of pores that are separated by pore walls, and the pore walls are constituted from a metal oxide. The composition of the metal oxide or the like that constitutes the porous layer is not particularly limited, but from the viewpoint of more reliably forming the porous layer in the manufacturing process of the structurally colored material, the metal oxide that constitutes the porous layer is preferably titanium oxide.

The thickness of the porous layer may be, for example, 50% or more and 90% or less of the thickness of the oxide film. The thickness of the porous layer can be measured based on a magnified photograph obtained by TEM observation.

The longest diameter of the pores contained in the porous layer is preferably 75 nm or less. In this case, scattering of visible light is more likely to occur in the porous layer, such that structural color can be more reliably exhibited on the structurally colored material. The longest diameter of pores contained in the porous layer can be measured based on a magnified photograph obtained by TEM observation. More specifically, in a magnified photograph obtained by TEM observation, two points are disposed on a contour of an individual pore so that the distance from each other is maximal. The distance between the two points at this time is taken as the longest diameter of the pore.

The dense layer is layered on the porous layer and is constituted from a metal oxide. In addition, the dense layer does not contain pores. The metal oxide that constitutes the dense layer and the metal oxide that constitutes the porous layer may be the same or may be different from each other, but from the viewpoint of more easily manufacturing the structurally colored material, the metal oxide that constitutes the dense layer and the metal oxide that constitutes the porous layer are preferably the same.

The thickness of the dense layer may be, for example, 10% or more and 50% or less of the thickness of the oxide film. The thickness of the dense layer can be measured based on a magnified photograph obtained by TEM observation.

The oxide film in the structurally colored material may be layered on the substrate. In addition, a layer that is different from the oxide film and the substrate may be provided between the oxide film and the substrate. For example, the structurally colored material may include a metal layer, which is composed of metal, and is interposed between the substrate and the porous layer. In this case, even if the substrate is not electrically conductive, anodizing treatment of the metal film can easily be performed in the manufacturing process of the structurally colored material to form a porous layer and a dense layer. Although the metal that constitutes the metal layer is not particularly limited, from the viewpoint of manufacturing the structurally colored material more easily, the metal layer is preferably constituted from the same metal element as the metal element contained in the metal oxide constituting the porous layer.

It is more preferable that the metal layer is constituted from titanium crystal grains, and the mean value of the longest diameter of the crystal grains is 10 nm or more and 50 nm or less. In this case, the porous layer can be more reliably formed in the manufacturing process of the structurally colored material. The longest diameter of the titanium crystal grain in the metal layer can be calculated based on a magnified photograph obtained by TEM observation. More specifically, in a magnified photograph obtained by TEM observation, two points are disposed on the grain boundary of a titanium crystal grain so that the distance from each other is maximal. The distance between the two points at this time is taken as the longest diameter of the titanium crystal grain.

### (Method of Manufacturing the Structurally Colored Material)

In preparing the structurally colored material, first, the metal film may be formed on the substrate by sputtering, and then the oxide film may be formed on the substrate, by performing an anodizing treatment on the metal film under the condition of a maximum voltage of 80 V or more and 200 V or less.

The metal film formed by sputtering is a polycrystal composed of a large number of crystal grains, and a large number of defects are present in the metal film. When such a metal film is subjected to an anodizing treatment, a large number of pores is formed in the interior of the oxide film, with the defects in the metal film serving as starting points. Thus, an oxide film that includes a porous layer and a dense layer can easily be formed by performing an anodizing treatment on the metal film that was formed by sputtering.

The specific method for sputtering is not particularly limited, and various methods, such as a two-electrode method, a three-electrode method, a four-electrode method, or a magnetron method, can be utilized. In addition, the power source for applying a voltage to the sputtering target may be a DC power source or may be a high-frequency power source.

From the viewpoint of more easily forming the oxide film that includes a porous layer and a dense layer, it is preferable to form the metal film by a DC magnetron sputtering method. In addition, from the same viewpoint, it is preferable that the metal layer is constituted from titanium crystal grains, and the mean value of the longest diameter of the crystal grains is 10 nm or more and 50 nm or less. The longest diameter of the titanium crystal grains in the metal film can be calculated based on a magnified photograph obtained by TEM observation. More specifically, in a magnified photograph obtained by TEM observation, two points are disposed on the grain boundary of a titanium crystal grain so that the distance from each other is maximal. The distance between the two points at this time is taken as the longest diameter of the titanium crystal grain.

The electrolytic solution used for the anodizing treatment may be a weakly acidic electrolytic solution or a weakly basic electrolytic solution. More specifically, in terms of the weakly acidic electrolytic solution, electrolytic solutions that contain, for example, phosphates, borates, adipic acid, or the like, as electrolytes, and have a pH of 3.5 or higher and 7 or lower can be used. In addition, in terms of the weakly basic electrolytic solution, electrolytic solutions that contain, for example, borates, phosphates, or the like, as electrolytes, and have a pH of 7 or higher and 8 or lower can be used.

From the viewpoint of more easily forming the oxide film that includes a porous layer and a dense layer, it is preferable to use an electrolytic solution containing phosphate ions in the anodizing treatment.

In the anodizing treatment, a voltage is applied to the metal film under the condition of a maximum voltage of 80 V or more and 200 V or less. The voltage applied to the metal film in the anodizing treatment may be a DC voltage, may be an AC voltage, or may be a pulsed voltage. In other words, in the anodizing treatment, a DC voltage of 80 V or more and 200 V or less may be applied to the metal film to perform DC electrolysis. In addition, in the anodizing treatment, an AC voltage having a peak voltage of 80 V or more and 200 V or less may be applied to the metal film to perform AC electrolysis. Furthermore, in the anodizing treatment, a pulsed voltage having a peak voltage of 80 V or more and 200 V or less may be applied to the metal film to perform pulsed electrolysis. When performing the anodizing treatment by any method, an oxide film that includes a porous layer and a dense layer can easily be formed by setting the maximum value of the voltage applied to the metal film in the range of 80 V or more and 200 V or less.

The treatment time for the anodizing treatment may be set as appropriate depending on the voltage applied to the metal film, the magnitude of the electric-current density, the thickness of the desired oxide film, and the like. For example, in terms of the anodizing treatment, the anodizing treatment may be performed on the metal film under conditions such that the entire metal film becomes a metal oxide. In this situation, a structurally colored material having an oxide film layered on a substrate can be obtained. In addition, in terms of the anodizing treatment, it is also possible to perform the anodizing treatment on the metal film under conditions such that a portion of the metal film becomes a metal oxide. In this situation, the portion of the metal film that has not been oxidized in the anodizing treatment becomes a metal layer, and a structurally colored material, which includes a substrate, a metal layer that is layered on the substrate, and an oxide film that is layered to the metal layer, can be obtained.

### Exemplary Embodiments

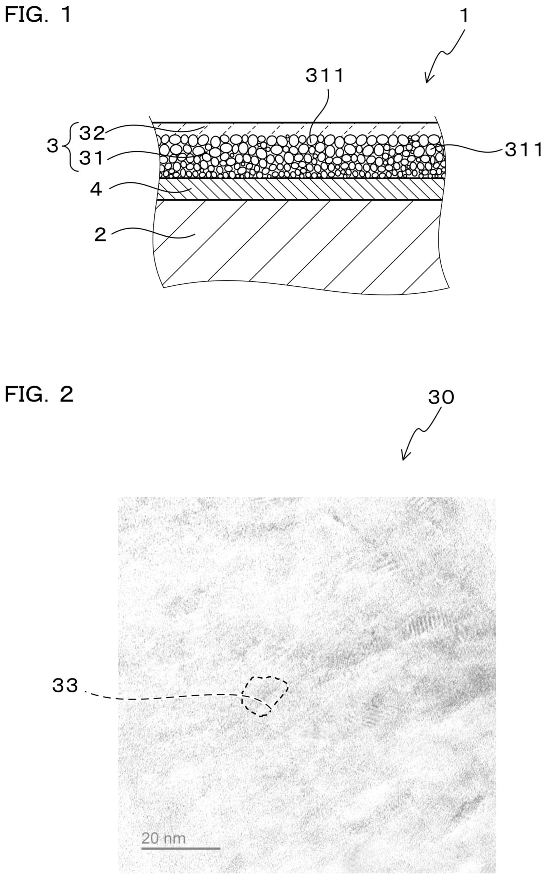

Exemplary embodiments of the aforementioned structurally colored material and the method for manufacturing the same will be described, with reference to FIG. 1 to FIG. 3. As shown in FIG. 1, a structurally colored material 1 of the present example includes a substrate 2 and an oxide film 3, which covers the substrate 2. The oxide film 3 includes a porous layer 31, which is disposed on the substrate 2, and a dense layer 32, which is layered on the porous layer 31. The porous layer 31 is constituted from a metal oxide and contains a plurality of pores 311. The dense layer 32 is constituted from a metal oxide. In addition, the dense layer 32 does not contain pores. When the thickness of the oxide film 3 is measured at various locations of the oxide film, the thickness of the oxide film 3 at each measurement location is within the range of 150 nm or more and 1000 nm or less and within the range of 0.75 times or more and 1.25 times or less with respect to the mean value of the thickness of the oxide film 3.

The structurally colored material in the present example is obtained by forming a metal film on the substrate by sputtering, and thereafter performing an anodizing treatment on the metal film under the condition of a maximum voltage of 80 V or more and 200 V or less to form an oxide film on the substrate. In the following, the constitutions of the structurally colored material and the method for manufacturing the same will be described in more detail.

The substrate in the structurally colored material of the present example is a sheet material, which has a thickness of 320 µm and is constituted from aluminum having a purity of 99.99%. It is noted that aluminum having a purity of 99.99% was recorded as "Al" in Table 1.

The oxide film in the present example is constituted from titanium oxide. In addition, a metal layer 4, which is composed of titanium, is present between the substrate 2 and the oxide film 3 in the structurally colored material 1 of the present example. The metal layer 4 is constituted from titanium crystal grains, which have a longest diameter of 10 nm or more and 50 nm or less.

When preparing the structurally colored material of the present example, electrolytic polishing is first performed on the substrate to smooth the surface of the substrate. The electrolytic solution used for the electrolytic polishing is, for example, a mixed solution in which acetic acid and perchloric acid are mixed at a ratio of acetic acid:perchloric acid = 78:22, as the volume ratio. In addition, the applied voltage in the electrolytic polishing may be, for example, 28 V, the temperature of the electrolytic solution may be, for example, 7°C, and the treatment time may be, for example, 2 minutes.

Next, after the electrolytic polishing has been performed, a metal film, which is composed of titanium and has a thickness of 100 nm, is formed on the substrate by a DC magnetron sputtering method. For example, titanium having a purity of 99.99 mass% may be used as the sputtering target. In addition, when the sputtering is performed, the sputtering current may be, for example, 150 mA, and the atmosphere may be, for example, an argon atmosphere having a pressure of 5.0 × 10⁻³ Pa. It is noted that titanium having a purity of 99.99% was recorded as "Ti" in Table 1.

FIG. 2 shows an example of a magnified photograph of a metal film 30 obtained by observing the metal film 30 using a TEM. On the basis of the magnified photograph shown in FIG. 2, the metal film 30 contains titanium crystal grains 33 having a longest diameter of 10 nm. When a magnified photograph of the metal film is obtained in multiple fields of view and the arithmetic mean value of the longest diameters of the titanium crystal grain contained in these magnified photographs is calculated, the mean value of the longest diameters of the titanium crystal grains is within the range of 10 nm or more and 50 nm or less.

After the metal film has been formed on the substrate, an anodizing treatment is performed on the metal film. In terms of the electrolytic solution in the anodizing treatment, for example, an aqueous phosphoric acid solution having a concentration of 0.3 mol/L can be used, as shown in Table 1. In addition, the temperature of the electrolytic solution in the anodizing treatment may be 20°C. The applied voltage in the anodizing treatment may be, for example, a DC voltage having the values shown in Table 1. In addition, the electric-current density in the anodizing treatment may be, for example, 1 mA/cm². It is noted that "mol/L" has been recorded abbreviated as "M" in Table 1.

The structurally colored materials shown in Table 1 (Test Materials A1 to A6) can be obtained in the foregoing manner. It is noted that Test Materials B1 to B6 shown in Table 1 are test materials for comparison with Test Materials A1 to A6.

Test Material B1 includes a substrate, which is composed of titanium having a purity of 99.99 mass%, and an oxide film, which is composed of titanium oxide and is formed on the substrate. The manufacturing method for Test Material B1 is the same as the manufacturing method for Test Materials A1 to A6, except that a sheet material composed of titanium having a purity of 99.99 mass% is used as the substrate, and the anodizing treatment is performed without forming a metal film on the substrate.

Test Material B2 includes a substrate, which is composed of an aluminum alloy that has a chemical composition indicated by the alloy number A5182, and an oxide film, which is composed of an aluminum oxide and is formed on the substrate. The manufacturing method for Test Material B2 is the same as the manufacturing method for Test Materials A1 to A6 except that: a sheet material, which is composed of an aluminum alloy that has a chemical composition indicated by alloy number A5182 is used as the substrate; the anodizing treatment is performed without forming a metal film on the substrate; an aqueous solution containing boric acid at a concentration of 0.5 mol/L and sodium tetraborate at a concentration of 0.05 mol/L is used as the electrolytic solution in the anodizing treatment; and the electric-current density in the anodizing treatment is changed to 5 mA/cm². The oxide film of Test Material B2 formed under such conditions is a so-called barrier-type anodic oxide film, which densely covers the substrate, and does not have pores such as those of the porous-type anodic oxide film.

Test material B3 includes a substrate, which is composed of aluminum having a purity of 99.99 mass%, and a metal film, which is composed of titanium and is formed on the substrate. The manufacturing method for Test Material B3 is the same as the manufacturing method for Test Materials A1 to A6, except that an anodizing treatment is not performed after the metal film has been formed on the substrate.

Test Material B4 and Test Material B6 generally have the same constitution as Test Materials A1 to A6, except that the thicknesses of the oxide films differ. The manufacturing method for Test Materials B4 and B6 is the same as the manufacturing method for Test Materials A1 to A6, except that the applied voltage in the anodizing treatment is varied as shown in Table 1.

Test Material B5 is constituted from a substrate composed of titanium having a purity of 99.99 mass%. In addition, an oxide film was not formed by an anodizing treatment on the substrate of Test Material B5.

Table 2 shows the results of the evaluation of the thickness of the oxide film, the longest diameter of the pores, and the color tone, for Test Materials A1 to A6 and Test Materials B1 to B6. The evaluation methods for these are as follows.

### Thickness of Oxide Film

Samples for TEM observation are taken from the test materials so that the entire oxide film in the thickness direction is included. The samples are observed at a magnification of 160,000 times or more and 200,000 times or less using a TEM, and magnified photographs of the oxide films are obtained. In these magnified photographs, the location where the thickness of the oxide film, which is to say, the sum of the thickness of the dense layer and the thickness of the porous layer, is the thickest is identified, and the thickness of the oxide film at this location is measured. The maximum values of the thickness of the oxide films obtained in this manner are as shown in Table 2.

In addition, in the magnified photographs, the location where the thickness of the oxide film is thinnest is identified, and the thickness of the oxide film at this location is measured. The minimum values of the thickness of the oxide films obtained in this manner are as shown in Table 2.

Furthermore, in the magnified photograph, five measurement locations are randomly set so as not to include locations at which the thickness of the oxide film is maximal and locations at which the thickness of the oxide film is minimal, and the thickness of the oxide film at these measurement locations is measured. Furthermore, the value for the arithmetic mean of these thicknesses is taken as the mean value of the thickness of the oxide film. The mean values of the thickness of oxide films are as shown in Table 2.

It is noted that the symbol "-" was recorded in the "Thickness of the Oxide Film" column in Table 2 for test materials for which measurement of the thickness of the oxide film was not performed.

### Longest Diameter of the Pores

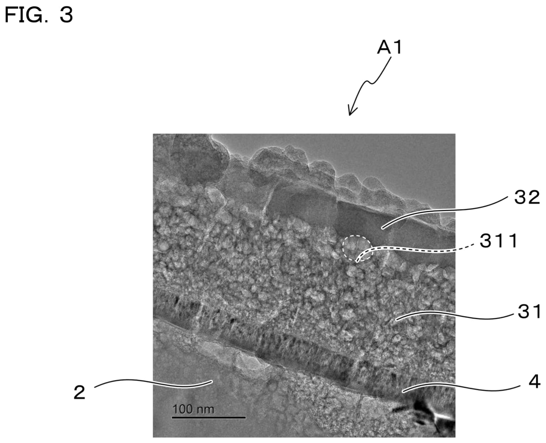

Samples for TEM observation are taken from the test materials so that the entire oxide film in the thickness direction is included. The samples are observed at a magnification of 160,000 times or more and 200,000 times or less using a TEM, and magnified photographs of the oxide films are obtained. As an example, FIG. 3 shows a magnified photograph obtained by observing the oxide film 3 of Test Material A1 using a TEM. As shown in FIG. 3, the oxide film 3 of Test Material A1 is constituted from a porous layer 31 containing a plurality of pores 311 and a dense layer 32 layered on the porous layer 31. In addition, a metal layer 4 is formed between the porous layer 31 and the substrate.

Next, based on a magnified photograph, the longest diameters of each of the pores contained in the porous layer are measured. The maximum value of the longest diameter of the pores obtained in this manner is shown in the "Longest Diameter of the Pores" column in Table 2. It is noted that, for test materials in which pores were not present in the oxide film, "no pores" was recorded in the "Longest Diameter of the Pores" column in Table 2, and for test materials for which measurement of the longest diameter of the pores was not performed, "-" was recorded in that column.

### Test Material Color Tone

The test material is placed on the stage of a stereomicroscope so that the normal to the surface of the oxide film and the direction of the line of sight, which is to say, the direction of the optical axis of the objective lens in the stereomicroscope, are parallel, and the color tone of the surface having the oxide film is observed using the stereomicroscope. The color tone at this time is shown in the "0°" column in Table 2.

Subsequently, the test material is inclined on the stage of the stereomicroscope such that the angle formed between the normal to the surface of the oxide film and the direction of line of sight is an angle of 20°, 40° or 60°, and the color tone of the surface having the oxide film is observed using the stereomicroscope. The color tones when the test material is inclined in this manner are shown in the "20°", "40°" and "60°" columns in Table 2, respectively.

### [Table 1]

**(Table 1)**

| Test Material Symbol | Substrate | Metal Film | Anodizing Treatment | | | |
|---|---|---|---|---|---|---|
| | | | Applied Voltage (V) | Electrolytic Solution | Temperature (°C) | Electric-Current Density (mA/cm2) |
| A1 | Al | Ti | 100 | aqueous 0.3 M phosphoric acid solution | 20 | 1 |
| A2 | Al | Ti | 150 | aqueous 0.3 M phosphoric acid solution | 20 | 1 |
| A3 | Al | Ti | 80 | aqueous 0.3 M phosphoric acid solution | 20 | 1 |
| A4 | Al | Ti | 120 | aqueous 0.3 M phosphoric acid solution | 20 | 1 |
| A5 | Al | Ti | 140 | aqueous 0.3 M phosphoric acid solution | 20 | 1 |
| A6 | Al | Ti | 160 | aqueous 0.3 M phosphoric acid solution | 20 | 1 |
| B1 | Ti | none | 100 | aqueous 0.3 M phosphoric acid solution | 20 | 1 |
| B2 | A5182 | none | 133 | aqueous 0.5m boric acid/0.05 M sodium tetraborate solution | 20 | 5 |
| B3 | Al | Ti | - | - | - | - |
| B4 | Al | Ti | 50 | aqueous 0.3 M phosphoric acid solution | 20 | 1 |
| B5 | Ti | none | - | - | - | - |
| B6 | Al | Ti | 60 | aqueous 0.3 M phosphoric acid solution | 20 | 1 |

### [Table 2]

**(Table 2)**

| Test Material Symbol | Thickness of Oxide Film (nm) | | | Longest Diameter of Pores (nm) | Color Tone | | | |
|---|---|---|---|---|---|---|---|---|
| | Maximum Value | Minimum Value | Mean Value | | 0° | 20° | 40° | 60° |
| A1 | 222 | 207 | 215 | 50 | dark blue | blue | purple | reddish purple |
| A2 | 297 | 290 | 293 | 50 | dark yellow | yellow | yellowish green | light blue |
| A3 | - | - | - | - | dark purple | purple | reddish purple | pink |
| A4 | - | - | - | - | dark yellowish green | green | bluish green | light blue |
| A5 | - | - | - | - | dark yellow | yellow | yellowish green | bright light blue |
| A6 | - | - | - | - | dark yellow | light yellow | light yellowish green | light green |
| B1 | 216 | 114 | 164 | 70 | grey | yellow | yellow | yellow |
| B2 | 201 | 176 | 190 | no pores | grey | grey | grey | grey |
| B3 | - | - | 5 | no pores | grey | grey | grey | grey |
| B4 | 105 | 98 | 100 | 25 | dark yellow | dark yellow | dark yellow | dark yellow |
| B5 | - | - | 5 | no pores | grey | grey | grey | grey |
| B6 | - | - | - | - | dark orange | dark orange | dark orange | dark yellow |

As shown in Table 1, Test Materials A1 to A6 are prepared by performing the anodizing treatment on the metal film under the specific conditions described above, after the metal film was formed on the substrate by sputtering. Therefore, the oxide film of these test materials includes a porous layer, which is formed on the substrate, and a dense layer, which is formed on the porous layer. In addition, as shown in Table 2, the thickness of the oxide film in these test materials is within the specific range described above. Therefore, the Test Materials A1 to A6 can exhibit structural color and can develop chromatic color having different color tones depending on the angle of the direction of the line of sight with respect to the test material.

On the other hand, because formation of a metal film by sputtering is not performed for the Test Material B1, the variation in the thickness of the oxide film formed by the anodizing treatment tends to be great. Consequently, Test Material B1 is unable to exhibit structural color and presents substantially the same color tone even if the angle of the direction of the line of sight with respect to the test material is changed.

For Test Material B2, a substrate composed of an aluminum alloy is subjected to an anodizing treatment. As described above, the oxide film formed in Test Material B2 is a barrier-type anodic oxide film that does not have pores and densely covers the substrate, and has a different structure than the oxide film in Test Materials A1 to A6. Consequently, Test Material B2 does not present a chromatic color.

Since Test Material B3 and Test Material B5 do not undergo an anodizing treatment, a natural oxide film is present on the surface of the substrate, which results from natural oxidation of the substrate. Such natural oxide films have thin thicknesses and do not include a porous layer. Therefore, Test Material B3 and Test Material B5 do not present chromatic color.

In Test Material B4 and Test Material B6, the thickness of the oxide film is thinner than the specific range described above and, therefore, complex scattering of visible light is not readily brought about in the oxide film. Consequently, these test materials are unable to exhibit structural color and present substantially the same color tone even if the angle of the direction of the line of sight with respect to the test material is changed.

Although the structurally colored material and the method for manufacturing the same have been described based on exemplary embodiments, the specific aspects of the structurally colored material and the method for manufacturing the same according to the present invention are not limited by the aspects in the exemplary embodiment, and the configurations thereof can be modified as appropriate within a scope that does not depart from the gist of the present invention.

For example, the structurally colored material can adopt the aspects indicated in [1] to [6] below.
[1] A structurally colored material including: a substrate; and
   an oxide film, which is composed of a metal oxide and covers the substrate,
   wherein the oxide film includes:
      a porous layer, which contains a plurality of pores and which is disposed on the substrate, and
      a dense layer, which does not contain pores and which is layered on the porous layer, and
   when the thickness of the oxide film is measured at various locations, the thickness of the oxide film at each measurement location is within the range of 150 nm or more and 1000 nm or less and within the range of 0.75 times or more and 1.25 times or less with respect to the mean value of the thickness of the oxide film.
[2] The structurally colored material according to [1], wherein the longest diameter of the pores contained in the porous layer is 75 nm or less.
[3] The structurally colored material according to [1] or [2], wherein the metal oxide, which constitutes the porous layer and the dense layer, is a titanium oxide.
[4] The structurally colored material according to any one of [1] to [3], wherein the structurally colored material is composed of metal and includes a metal layer interposed between the substrate and the porous layer.
[5] The structurally colored material according to [4], wherein the metal layer is constituted from titanium crystal grains, and the mean value of the longest diameter of the crystal grains is 10 nm or more and 50 nm or less.
[6] The structurally colored material according to any one of [1] to [5], wherein the substrate is constituted from aluminum or an aluminum alloy.

In addition, the method for manufacturing the structurally colored material can utilize, for example, the aspects indicated in [7] to [9] below.

[7] A method of manufacturing a structurally colored material according to any one of [1] to [6], wherein:
a (the) metal film is formed on the substrate by sputtering, and
thereafter the oxide film is formed on the substrate by performing an anodizing treatment on the metal film under the condition of a maximum voltage of 80 V or more and 200 V or less.

[8] The method of manufacturing a structurally colored material according to [7], wherein the metal film is constituted from titanium crystal grains, and the mean value of the longest diameter of the crystal grains is 10 nm or more and 50 nm or less.

[9] A method of manufacturing a structurally colored material according to [7] or [8], wherein an electrolytic solution containing phosphate ions is used in the anodizing treatment.

## Claims

1. A structurally colored material including:
a substrate, and
an oxide film, which is composed of a metal oxide and which covers the substrate,
wherein the oxide film includes:
a porous layer, which contains a plurality of pores and which is disposed on the substrate,
a dense layer, which does not contain pores and which is layered on the porous layer, and
when the thickness of the oxide film is measured at various locations, the thickness of the oxide film at each measurement location is within the range of 150 nm or more and 1000 nm or less and within the range of 0.75 times or more and 1.25 times or less with respect to the mean value of the thickness of the oxide film.

2. The structurally colored material according to claim 1, wherein the longest diameter of the pores contained in the porous layer is 75 nm or less.

3. The structurally colored material according to claim 1 or 2, wherein the metal oxide, which constitutes the porous layer and the dense layer, is a titanium oxide.

4. The structurally colored material according to any one of claims 1 to 3, wherein the structurally colored material is composed of metal and includes a metal layer interposed between the substrate and the porous layer.

5. The structurally colored material according to claim 4, wherein the metal layer is constituted from titanium crystal grains, and the mean value of the longest diameter of the crystal grains is 10 nm or more and 50 nm or less.

6. The structurally colored material according to any one of claims 1 to 5, wherein the substrate is constituted from aluminum or an aluminum alloy.

7. A method of manufacturing the structurally colored material according to any one of claims 1 to 6, wherein:
a (the) metal film is formed on the substrate by sputtering, and
thereafter the oxide film is formed on the substrate by performing an anodizing treatment on the metal film under the condition of a maximum voltage of 80 V or more and 200 V or less.

8. The method for manufacturing a structurally colored material according to claim 7, wherein the metal film is constituted from titanium crystal grains, and the mean value of the longest diameter of the crystal grains is 10 nm or more and 50 nm or less.

9. A method for manufacturing a structurally colored material according to claim 7 or 8, wherein an electrolytic solution containing phosphate ions is used in the anodizing treatment.
